(19) Europäisches Patentamt
European Patent Office
Office européen des brevets

(11) **EP 1 204 207 B1**

(12) **EUROPÄISCHE PATENTSCHRIFT**

(45) Veröffentlichungstag und Bekanntmachung des Hinweises auf die Patenterteilung:
**26.09.2007 Patentblatt 2007/39**

(51) Int Cl.:
***H03H 11/12*** *(2006.01)*

(21) Anmeldenummer: **00122512.7**

(22) Anmeldetag: **14.10.2000**

(54) **Aktive Filterschaltung mit Operationsverstärker**

Active filter circuit with operational amplifier

Circuit de filtrage actif à amplificateur opérationnel

(84) Benannte Vertragsstaaten:
**DE FR GB IT NL**

(43) Veröffentlichungstag der Anmeldung:
**08.05.2002 Patentblatt 2002/19**

(73) Patentinhaber: **Micronas GmbH**
**79108 Freiburg i. Br. (DE)**

(72) Erfinder:
• **Greitschus, Norbert, Dr.-Ing.**
**79346 Endingen (DE)**
• **Noe, Stefan, Dipl.-Phys.**
**70563 Stuttgart (DE)**

(56) Entgegenhaltungen:
• **ANANDA MOHAN: "Predistortion of Friend's single amplifier Biquad" 1985 INT. SYMP. ON CIRCUITS AND SYSTEMS PROC.; , Bd. 1, 5. Juni 1985 (1985-06-05), Seiten 287-290, XP002163523 kyoto**
• **GRAEME J G: "FEEDBACK PLOTS OFFER INSIGHT INTO OPERATIONAL AMPLIFIERS" EDN ELECTRICAL DESIGN NEWS,US,CAHNERS PUBLISHING CO. NEWTON, MASSACHUSETTS, Bd. 34, Nr. 2, 19. Januar 1989 (1989-01-19), Seiten 131-136,138,14, XP000051235 ISSN: 0012-7515**
• **G. ZUCH AND J. KNITER: "hIGH-SPEED OP AMPS- THEY'RE IN A CLASS BY THEMSELVES" EDN ELECTRICAL DESIGN NEWS., Bd. 22, Nr. 16, September 1977 (1977-09), Seiten 99-104, XP002163522 CAHNERS PUBLISHING CO. NEWTON, MASSACHUSETTS. 81963 1, US ISSN: 0012-7515**

EP 1 204 207 B1

**Beschreibung**

Die Erfindung betrifft eine aktive Filterschaltung mit einem Operationsverstärker, die der Bildung von Tiefpaßfiltern höherer Ordnung dient. Tiefpaßfilter höherer Ordnung lassen sich bekanntlich realisieren, indem Glieder zweiter Ordnung bzw. Glieder zweiter Ordnung und ein Glied erster Ordnung rückwirkungsfrei in Kette geschaltet werden. Diese Filterschaltungen vermeiden die Verwendung von Induktivitäten, erfordern jedoch als aktive Schaltung einen idealisierten Verstärker, der in der Regel ein Operationsverstärker ist. Mit diesem idealisierten Verstärker wird eine aktive Gegen- oder Mitkopplung realisiert und zugleich die Rückwirkungsfreiheit innerhalb und außerhalb des jeweiligen Tiefpaßfilters sichergestellt.

Es sind verschiedene Realisierungen des Tiefpaßfilters zweiter Ordnung mit Operationsverstärkern bekannt: Aktive Filterschaltungen mit drei Operationsverstärkern, vgl. Fig. 1, aktive Filterschaltungen mit Mehrfachgegenkopplung, vgl. Fig. 2 und aktive Filterschaltungen mit Einfachmitkopplung. vgl. Fig. 3. Alle diese Schaltungen realisieren die Übertragungsfunktion eines Tiefpasses zweiter Ordnung mit der allgemein bekannten Übertragungsfunktion:

$$G(p) = \frac{v'}{1 + a \cdot \frac{p}{\omega_g} + b \cdot \frac{p^2}{\omega_g^2}} \qquad \text{(Gleichung 1)}$$

Dabei bedeuten:

p     Laplace-Operator
$\omega_g$     Grenzfrequenz des Tiefpaßfilters
$v'$     Durchlaßverstärkung des Tiefpaßfilters
$a$     erster Filterkoeffizient der Übertragungsfunktion
$b$     zweiter Filterkoeffizient der Übertragungsfunktion

Die dimensionslosen Filterkoeffizienten a und b der Übertragungsfunktion $G(p)$ werden durch die Dimensionierung des jeweiligen RC-Netzwerkes eingestellt. Damit und durch die rückwirkungsfreie Hintereinanderschaltung von derartigen Tiefpaßfiltern, in der Regel mit unterschiedlichen Filterkoeffizienten, lassen sich Filter mit vorgegebenen Eigenschaften realisieren. Bekannte Beispiele für verschiedene Filtertypen sind Bessel-, Butterworth-, und Tschebyscheff-Filter, Diese Filtertypen unterscheiden sich nur durch verschiedene Filterkoeffilzienten $a_i$ und $b_i$. Nähere Erläuterungen finden sich beispielsweise in U. Tietze und Ch. Schenk, "Halbleiter-Schaltungstechnik", 10. Auflage, Springer-Verlag, 1993, ISBN 3-540-56184-6 im Kapitel 14.1 "Theoretische Grundlagen von Tiefpaßfiltern", Seiten 391 bis 413.

Der Nachteil dieser bekannten Schaltungen ist, daß bei einer hohen Grenzfrequenz des Tiefpaßfilters die Übertragungsfunktion des Verstärkers die gewünschte Übertragungsfunktion des Tiefpaßfilters durch ihre realen Frequenz- und Phaseneigenschaften gegebenenfalls beeinflußt. Um das zu vermeiden oder den Einfluß vernachlässigen zu können, muß der gegenkoppelbare Operationsverstärker mit seiner Transitfrequenz $f_T$ weit außerhalb der gewünschten Tiefpaßcharakteristik liegen. Die Realisierung einer hohen Grenzfrequenz des Tiefpasses erfordert je nach geforderter Genauigkeit eine hohe Transitfrequenz des Operationsverstärkers, die mindestens um den Faktor 20 bis 100 höher ist als die Grenzfrequenz des Tiefpaßfilters. Die hochfrequente Umladung der jeweiligen parasitären oder Lastkapazitäten erfordert eine hohe Stromaufnahme des Operationsverstärkers; gegebenenfalls ist die Realisierung der hohen Transitfrequenz gar nicht möglich

In dem Artikel"Feetback Plots Offer Insight into Operational Amplifiers" aus Electrical Design News 19.01.1989 von Gerald Graeme ist beschrieben, wie sich der Frequenzgang eines Operationsverstärkers auf die Obertragscharakteristik einer Verstärkerschaltung auswirken kann und wie dies durch ein RC-Netzwerk kompensiert werden kann.

Aufgabe der Erfindung ist es, eine aktive Filterschaltung zur Realisierung eines aktiven Tiefpaßfilters mit definierter Charakteristik für relativ hohe Durchlaßfrequenzen anzugeben, welche den Nachteil der hohen Stromaufhahme vermeidet.

Diese Aufgabe wird durch eine Filterschaltung nach Anspruchs 1 gelöst.

Die Einbeziehung des Frequenzganges des Tiefpaßfilters erfolgt gezielt durch eine Vorgabe der Transitfrequenz $f_T$ des Operationsverstärkers, wobei die vorzugebende Transitfrequenz über die gewünschte Übertragungsfunktion $G(p)$ des jeweiligen Tiefpaßfilters, das aus einem RC-Netzwerk und mindestens einem frequenzgangbehafteten realen Operationsverstärker besteht, bestimmt wird. Dadurch ist die Verwendung von Operationsverstärkern mit relativ geringer Transitfrequenz $f_T$ und damit geringer Stromaufnahme möglich.

Die Erfindung und vorteilhafte Ausgestaltungen werden nun anhand der Figuren der Zeichnung näher erläutert:

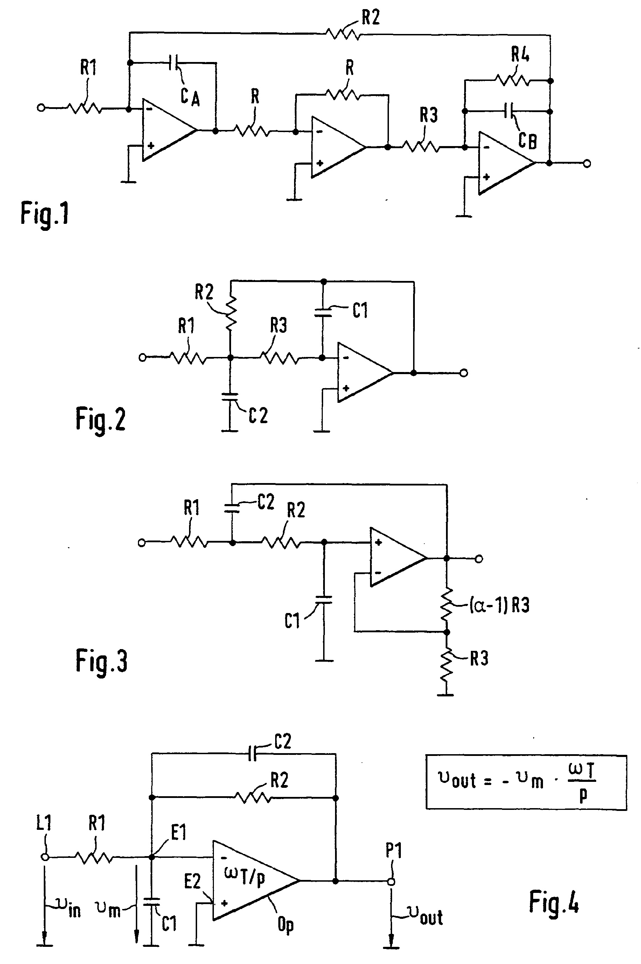

Fig. 1 zeigt eine bekannte Filterschaltung mit drei Operationsverstärkern,

Fig. 2 zeigt eine bekannte Filterschaltung mit Mehrfachgegenkopplung,

Fig. 3 zeigt eine bekannte Filterschaltung mit Einfachmitkopplung,

Fig. 4 zeigt als Blockschaltbild ein Ausführungsbeispiel der Erfindung,

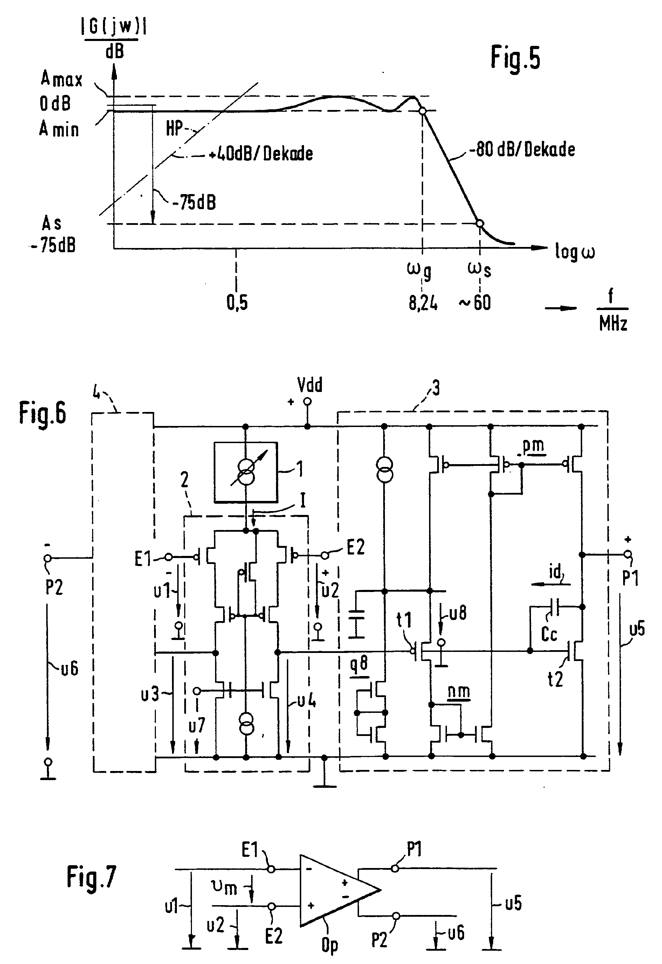

Fig. 5 zeigt schematisch im Frequenzdiagramm einen Tiefpaß vierter Ordnung,

Fig. 6 zeigt ein Ausführungsbeispiel für einen symmetrischen Operationsverstärker,

Fig. 7 zeigt die zugehörige Symboldarstellung,

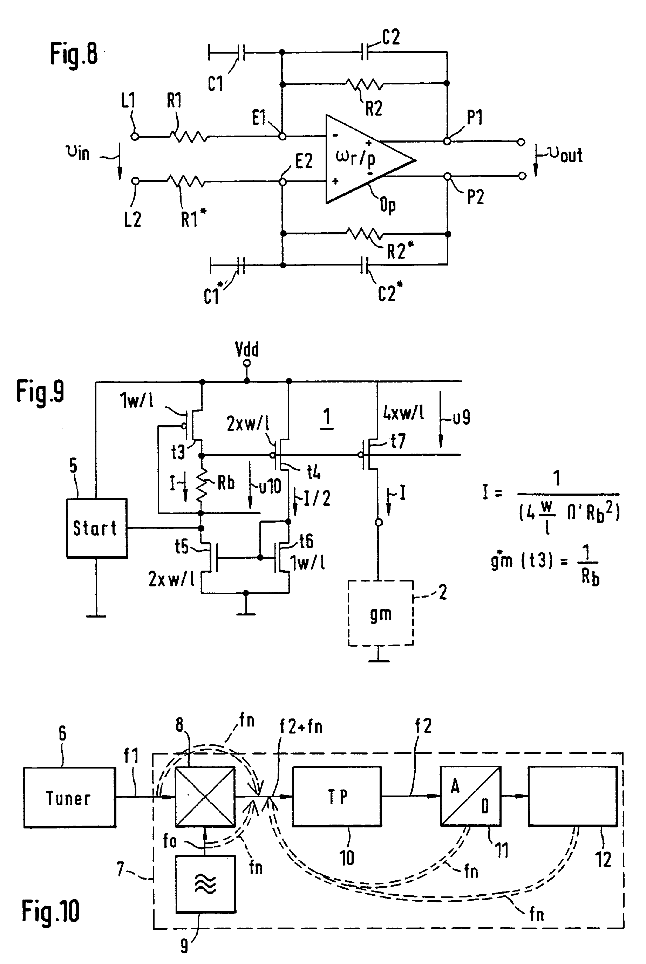

Fig. 8 zeigt schematisch ein aktives Tiefpaßfilter in symmetrischer Ausführung,

Fig. 9 zeigt ein Ausführungsbeispiel einer Bias-Schaltung zur Steilheitssteuerung und

Fig. 10 zeigt als Blockschaltbild ein Anwendungsbeispiel für das Tiefpaßfilter.

Fig. 1 zeigt ein bekanntes Schaltschema eines relativ aufwendigen Tiefpaßfilters zweiter Ordnung mit drei Operationsverstärkern. Die zweite Ordnung bedingt zwei Zeitkonstanten, die durch zwei Kondensatoren $C_A$ und $C_B$ in Verbindung mit sechs Widerständen R, R, $R_1$, $R_2$, $R_3$ und $R_4$ gebildet werden.

Fig. 2 zeigt ein anderes bekanntes Schaltschema eines aktiven Tiefpaßfilters zweiter Ordnung mit Mehrfachgegenkopplung. Die Schaltung ist infolge der Mehrfachgegenkopplung wesentlich einfacher als die von Fig. 1 und erfordert nur einen einzigen Operationsverstärker. Die beiden Zeitkonstanten werden durch ein RC-Netzwerk im Mehrfachgegenkopplungszweig gebildet, das zwei Kondensatoren $C_1$ und $C_2$ in Verbindung mit drei Widerständen $R_1$, $R_2$ und $R_3$ enthält. Durch Anwendung der Knoten- und Maschenregel läßt sich die Übertragungsfunktion $G(p)$ angeben. Bei monolithischer Integration ist darauf zu achten, daß die Kondensatoren und die Widerstände vernünftige Werte aufweisen.

Fig. 3 zeigt schließlich ein ebenfalls bekanntes Schaltschema eines aktiven Tiefpaßfilters zweiter Ordnung mit einer Einfachmitkopplung. Auch hier bestimmen zwei Kondensatoren $C_1$, $C_2$ in Verbindung mit vier Widerständen $R_1$, $R_2$, $(\alpha-1)R_3$ und $R_3$ die beiden Zeitkonstanten.

Die Auswahl der Schaltungsbeispiele Fig. 1 bis 3 soll zeigen, daß es eine Vielzahl von Möglichkeiten gibt, aktive Tiefpaßfilter zweiter Ordnung zu realisieren. Für alle Schaltungsvarianten gilt die eingangs angegebene Übertragungsfunktion $G(p)$ entsprechend Gleichung 1. Allerdings wird hierbei der Operationsverstärker als ideal angenommen, mindestens besitzt der Operationsverstärker keine frequenzabhängige Übertragungsfunktion, bzw. ist diese im interessierenden Frequenzbereich zu vernachlässigen. Umgekehrt kommt man aus der allgemeinen Übertragungsfunktion $G(p)$ durch Einsetzen der gewünschten Filterparameter $a$ und $b$ und einen Koeffizientenvergleich mit der schaltungsabhängigen Übertragungsfunktion auf die Bestimmungsgleichungen für die in dem jeweiligen RC-Netzwerk enthaltenen Kondensatoren und Widerstände. Als schaltungsabhängige Übertragungsfunktion ist hier diejenige Übertragungsfunktion zu verstehen, in der die Elemente des jeweiligen RC-Netzwerkes als tatsächliche Werte und nicht verallgemeinert in normierter Form vorhanden sind.

Bei der erfindungsgemäßen Schaltung können die Werte der RC-Elemente ebenfalls aus einem Koeffizientenvergleich gewonnen werden. Hierbei wird der Operationsverstärker jedoch nicht als idealer Verstärker mit unendlicher Verstärkung und unendlicher Grenzfrequenz angesehen. Die Verstärkung ist eine frequenzabhängige Größe, die vereinfacht durch ihre Transitfrequenz $f_T$ bzw. $\omega_T$ definiert ist. Das ergibt ein Gleichungssystem, das die voneinander abhängigen Elemente des RC-Netzwerkes und die Transitfrequenz enthält. Durch die Vorgabe einzelner Elemente können dann die anderen Elemente über die einzelnen Bestimmungsgleichungen berechnet werden.

Von Vorteil bei der monolithischen Integration ist die Möglichkeit der gemeinsamen Variation der Werte der einzelnen Elemente, so daß sich herstellungsbedingte Toleranzen bei einer geeigneten Schaltungsauslegung auf die Charakteristik des Tiefpaßfilters - auch bei mehreren hintereinandergeschalteten Stufen - kaum auswirken. Auch sind die Kondensatoren im Gegensatz zu diskreten Bauelementen beliebig fein abstufbar. Bei der Bestimmung der einzelnen

Elemente werden die einzelnen Werte gegeneinander abgewogen, um unter Berücksichtigung der Integrierbarkeit und Genauigkeit ein Optimum zu finden.

Die erfindungsgemäße Einbeziehung des Frequenzgangs des Operationsverstärkers in die Übertragungsfunktion des Filters wird anhand des Schaltungsbeispieles von Fig. 4 erläutert. Zunächst wird die Übertragungsfunktion $G(p) = v_{out} / v_{in}$ über die Knoten- und Maschenregel bestimmt. Hierzu wird hilfsweise eine Knotenspannung $v_m$ herangezogen, die an einem zentralen Knoten liegt, der auch den invertierenden Eingang E1 des Operationsverstärkers Op bildet. Nun können nach der Knotenregel vorzeichenrichtig alle Ströme des Knotens E1 bestimmt werden, wobei der invertierende Eingang des implementierten Operationsverstärkers Op als stromlos angesehen wird. Da die Summe aller Ströme in oder aus dem Knoten E1 den Wert Null hat, ergibt dies folgende Gleichung 2:

$$(v_m - v_{out}) \cdot \left( \frac{1}{R_2} + p \cdot C_2 \right) = -v_m \cdot p \cdot C_1 + \frac{v_{in} - v_m}{R_1} \qquad \text{(Gleichung 2)}$$

Die Berücksichtigung des Frequenzganges des Operationsverstärkers Op erfolgt näherungsweise durch die Angabe seiner Transitfrequenz $f_T$. Die zugehörige Kreisfrequenz ist $\omega_T = 2\pi f_T$. Die Eingangsspannung des Operationsverstärkers, die Knotenspannung $v_m$, ist mit seiner Ausgangsspannung $v_{out}$ über die Transitfrequenz nach Gleichung 3 verknüpft:

$$v_{out} = -\frac{\omega_T}{p} \cdot v_m \qquad \text{(Gleichung 3)}$$

Aus Gleichungen 2 und 3 wird nach einigen Umstellungen die schaltungsabhängige Übertragungsgleichung $G(p) = v_{out} / v_{in}$ gebildet, die nur noch die Elemente der Schaltung von Fig. 4 enthält.

$$G(p) = -\frac{R_2}{R_1} \cdot \frac{1}{(1 + \frac{p}{\omega_T}) \cdot (1 + p \cdot R_2 C_2) + \frac{p}{\omega_T} \cdot (p \cdot C_1 R_2 + \frac{R_2}{R_1})} \qquad \text{(Gleichung 4)}$$

Die Gleichung 4 kann mit folgenden zweckmäßigen Substitutionen für den Koeffizientenvergleich mit der Grundgleichung 1 der Übertragungsfunktion umgeformt werden:

$v' = \dfrac{R_2}{R_1}$   Verstärkung des Tiefpaßfilters im Durchlaßbereich

$\tau_1 = R_1.C_1$   erste Zeitkonstante

$\tau_2 = R_2.C_2$   zweite Zeitkonstante

Damit ergibt sich folgende Übertragungsgleichung $G(p)$:

$$G(p) = \frac{-v'}{(1 + p \cdot (\tau_2 + \frac{1+v'}{\omega_T}) + p^2 \cdot (\frac{\tau_2}{\omega_T} + \tau_1 \cdot \frac{v'}{\omega_T})} \qquad \text{(Gleichung 5)}$$

Der Koeffizientenvergleich der Gleichung 1 und Gleichung 5 liefert dann für das jeweilige Tiefpaßfilter und die jeweilige Filtergrenzfrequenz $\omega_g$, die charakteristischen Koeffizienten $a$ und $b$ in Abhängigkeit von $v'$, $\tau_1$, $\tau_2$ und $\omega_T$ entsprechend den Gleichungen 6 und 7:

$$a = \omega_g \cdot \left( \tau_2 + \frac{1+v'}{\omega_T} \right) \qquad \text{(Gleichung 6)}$$

$$b = \omega_g^2 \cdot \frac{\tau_2 + v' \tau_1}{\omega_T} \qquad \text{(Gleichung 7)}$$

Wenn der Eingangswiderstand $R_1$ und die Transitfrequenz $\omega_T$ vorgegeben wird, dann ergeben sich die übrigen Elemente des RC-Netzwerkes von Fig. 4 in Abhängigkeit von der gewünschten Filtergrenzfrequenz $\omega_g$ aus den folgenden Gleichungen 8, 9 und 10:

$$R_2 = v' \cdot R_1 \qquad \text{(Gleichung 8)}$$

$$C_2 = \frac{1}{R_2} \cdot \left( \frac{a}{\omega_g} - \frac{1+v'}{\omega_T} \right) \qquad \text{(Gleichung 9)}$$

$$C_1 = \frac{b \cdot \omega_T}{R_2 \cdot \omega_g^2} - C_2 \qquad \text{(Gleichung 10)}$$

Die Reduktion der erforderlichen Transitfrequenz der Operationsverstärker wird anhand des schematischen Frequenzdiagramms Fig. 5 an einem Ausführungsbeispiel verdeutlicht. Es zeigt in doppellogarithmischer Darstellung den Frequenzgang $|G(j\omega)|$ eines Tschebyscheff-Tiefpaßfilters vierter Ordnung, das mit zwei hintereinandergeschalteten Tiefpaßfiltern zweiter Ordnung realisiert ist und in der Nähe der Grenzfrequenz $\omega_g$ eine steile Filterflanke aufweist. Das Verhältnis der beiden vorzugebenden Werte $A_{max}$ und $A_{min}$ im Durchlaßbereich heißt Welligkeit des Tschebyscheff-Tiefpaßfilters. Sie ist im Ausführungsbeispiel mit $A_{max}/A_{min} = 0,01$ dB sehr gering. Die Weitabdämpfung wird durch die vierfache Ordnung des Tiefpaßfilters bestimmt und weist einen Frequenzgang von -80 dB/Dekade auf. Wenn im Übergangsbereich von der bei $2\pi\cdot8,24$ MHz liegenden Grenzfrequenz $\omega_g$ bis zu einer Weitabfrequenz $\omega_s$ von ca. $2\pi\cdot60$ MHz die durchgelassenen Signale definiert bis auf etwa -70 dB abgesenkt werden sollen, dann müssen Amplituden- und Phasengang des aktiven Filters mindestens innerhalb dieses Frequenzbereichs der vorgegebenen Charakteristik entsprechen.

Sollen zusätzlich die Gleichspannung und tiefe Signalfrequenzen, beispielsweise unterhalb von 500 kHz, unterdrückt werden, dann lassen sich diese Frequenzbereiche auf einfache Weise mittels eines oder zweier in Reihe geschalteter Hochpässe dämpfen. Dem entspricht in Fig. 5 die strichpunktiert dargestellte Hochpaßflanke HP, die einen Frequenzgang von +40 dB/Dekade aufweist. Derartige Hochpässe sind leicht mit dem aktiven Tiefpaßfilter kombinierbar, beispielsweise durch einen Kondensator zwischen dem jeweiligen Filtereingang und dem Widerstand R1, vgl. die Figuren 1 bis 4.

Die Welligkeit des Tschebyscheff-Tiefpasses soll in dem beschriebenen Ausführungsbeispiel mit $A_{max}/A_{min} = 0,01$ dB relativ klein sein. Die vorgegebene Grenzfrequenz $\omega_g$ soll bei $2\pi\cdot8,24$ MHz liegen. Die -3dB-Grenzfrequenz liegt wegen der Welligkeitsvorgabe höher, etwa bei 12 MHz. Das aktive Tiefpaßfilter umfaßt mit der geforderten Weitabfrequenz $\omega_s$ insgesamt einen Frequenzbereich bis etwa $2\pi\cdot60$ MHz, der deutlich höher als die Filtergrenzfrequenz $\omega_g = 2\pi\cdot8,24$ MHz ist. Wenn die Transitfrequenz des Operationsverstärkers im Hinblick auf das Frequenzverhalten des RC-Netzwerkes vernachlässigbar sein soll, käme man schon bei einem Faktor von 20 über der Filtergrenzfrequenz $\omega_g$ auf eine Transitfrequenz $f_T = 164,8$ MHz, die mit den üblichen Technologien für monolithisch integrierte Schaltungen nur mit hoher Stromaufnahme des Operationsverstärkers zu realisieren ist. Nach der Erfindung ist jedoch eine Realisierung mit einer wesentlich niedrigeren Transitfrequenz für den Operationsverstärker möglich. Die gewünschte Frequenzunterdrückung ist nach der Erfindung mit einer aktiven Filterschaltung erzielbar, deren Operationsverstärker nur eine Transitfrequenz im Bereich von 60 MHz erfordert.

In Fig. 6 ist das Schaltbild eines Operationsverstärkers Op in CMOS-Technik dargestellt, der als Verstärker in einer aktiven Filterschaltung verwendet werden kann. Das dargestellte Beispiel ist weitgehend symmetrisch ausgeführt, um möglichst unempfindlich gegenüber parasitären Signaleinkopplungen zu sein, insbesondere wenn diese Signale auf dem gleichen Chip mit anderen Schaltungsteilen erzeugt werden.

Das Schaltbild von Fig. 6 zeigt vier Schaltungsblöcke. Der Schaltungsblock 1 enthält eine Bias-Schaltung zur Erzeugung eines eingeprägten Stromes $I$ für einen im Schaltungsblock 2 dargestellten symmetrischen Eingangsverstärker. Die beiden Schaltungsblöcke 3, 4 sind zueinander symmetrisch und bilden jeweils einen mit dem Eingangsverstärker 2 verbundenen Ausgangsverstärker. Wegen der zum ersten Ausgangsverstärker 3 symmetrischen Ausbildung des zweiten Ausgangsverstärkers 4 ist in Fig.6 die Innenschaltung des zweiten Ausgangsverstärkers 4 nicht dargestellt.

Der Eingangsverstärker 2 enthält zur Bildung eines invertierenden und nichtinvertierenden Eingangs E1, E2 als Eingangsdifferenzstufe ein p-Kanal-Transistorpaar, das von einer Stromquelle, nämlich Transistor t7, in der Bias-Schaltung 1 gespeist wird. Durch eine Steuerung des Ausgangsstromes $I$ in der Bias-Schaltung 1 kann die Steilheit $g_m$

des Eingangsverstärkers 2 geändert werden. Die beiden Eingänge E1, E2 werden mit einem Differenzsignal bzw. mit einer ersten und zweiten Eingangsspannung *u1, u2* gespeist. Die Eingangsdifferenzstufe ist über ein p-Kanal-Kaskodetransistorpaar mit einer n-Kanal-Strombank als hochohmige Last zur Auskopplung einer Differenzausgangsspannung oder zur Auskopplung von zwei zugehörigen, massebezogenen Ausgangsspannungen *u3, u4* verbunden. Die Gatespannung der n-Kanal-Strombank ist durch eine Hilfsspannung *u7* festgelegt. Die Größe der Differenzausgangsspannung oder der Ausgangsspannungen *u3, u4* ist sowohl von der Eingangsdifferenzspannung $v_m = u1 - u2$ (vgl. Fig. 4 und Fig. 7) als auch von dem von der Bias-Schaltung 1 eingespeisten Strom *I* abhängig.

Die Ausgangssignale *u3, u4* des Eingangsverstärkers 2 dienen als Eingangssignale für die beiden Ausgangsverstärker 3, 4, deren Ausgangsspannungen *u5, u6* die Ausgangsspannungen des symmetrischen Operationsverstärkers Op und der Filterstufe 2. Ordnung bilden. Für die beiden im Gegentakt angesteuerten Ausgangsstufen 3, 4 eignet sich vorzugsweise die im Schaltungsblock 3 von Fig. 6 dargestellte A/B-Gegentaktschaltung, weil sie eine gute Linearität zwischen dem am Knoten P 1 gebildeten Differenz-Ausgangsstrom *id* und der Gate-Source-Ansteuerspannung *u4* des komplementären Ausgangstransistorpaares t1, t2 aufweist. Die Funktionsweise der in Fig. 6 dargestellten A/B-Gegentaktschaltung mit den beiden hintereinandergeschalteten Stromspiegeln nm, pm und der Spannungsquelle q8 für das feste Source-Potential u8 von Transistor t1 ist in der eigenen Patentanmeldung EP 0 460 263 Al (intern: C-1417) ausführlich beschrieben. Die kapazitive Gegenkopplung der Ausgangsstufe 3 bzw. 4 bildet eine klassische Frequenzkompensation nach dem Miller-Prinzip - vgl. hierzu den Miller-Kondensator Cc in der Ausgangsstufe 3. Damit kann die Forderung nach einer definierten Frequenzgangabsenkung des Operationsverstärkers mit -20 dB/Dekade erfüllt werden: Die Übertragungsfunktion des Operationsverstärkers $G_{Op}(p)$ kann annähernd durch Gleichung 11

$$G_{Op}(p) = \frac{g_m}{p \cdot C_C} = \frac{\omega_T}{p} \qquad \text{(Gleichung 11)}$$

beschrieben werden.

Fig. 7 zeigt schematisch die zum symmetrischen Operationsverstärker von Fig. 6 gehörige Symboldarstellung des Operationsverstärkers Op mit den Ein- und Ausgängen E1, E2 bzw. P1, P2 für die Spannungen *u1, u2* bzw. *u5, u6*.

Fig. 8 zeigt eine Ergänzung der unsymmetrischen Tiefpaßschaltung von Fig. 4 zu einer vollständig symmetrischen Tiefpaßschaltung. Dies wird durch den symmetrischen Operationsverstärker Op von Fig. 6 und Fig. 7 ermöglicht, der über seine beiden Ausgänge P1, P2, die einem nichtinvertierenden bzw. einem invertierenden Ausgang entsprechen, die symmetrische Ergänzung des aktiven Tiefpaßfilters ermöglicht. Die symmetrisch ergänzten Bauelemente sind in Fig. 8 durch ein Sternsymbol (siehe: *) gekennzeichnet. Das Frequenzverhalten wird durch die Symmetrierung selbstverständlich nicht beeinflußt.

In Fig. 9 ist ein Ausführungsbeispiel der Bias-Schaltung 1 dargestellt. Sie enthält zur Erzeugung eines vorgegebenen Stromes *I* eine Regelschaltung aus zwei über Kreuz verkoppelten Stromspiegeln unterschiedlicher Polarität. Der erste Stromspiegel enthält die p-Kanal-Transistoren t3, t4 und der zweite Stromspiegel die n-Kanal-Transistoren t4, t5. Die Transistoren t3 und t6 sind als Dioden geschaltet und definieren den Strom der zugehörigen Stromspiegel. Die Kreuzverkopplung der Transistoren erfolgt über die Drainstrecken der Transistoren t3, t5 bzw. t4, t6. Der p-Kanal-Stromspiegel weicht indessen von der üblichen Schaltungskonfiguration für Stromspiegel ab, indem für die beiden Transistoren t3, t4 unterschiedliche Gate-Source-Spannungen vorgesehen sind. Die Gate-Source-Spannung des als Diode geschalteten Transistors t3 ist im stationären Betriebszustand des Ausführungsbeispieles von Fig. 9 doppelt so groß wie die Gate-Source-Spannung des Transistors t4. Dies wird durch einen im Drain-Strompfad von Transistor t3 liegenden Widerstand Rb erzwungen, an dem der Drainstrom einen Spannungsabfall erzeugt, der im eingeschwungenen Betriebszustand gleich groß wie die Gate-Source-Spannung am Transistor t4 ist. Der Gate-Anschluß von Transistor t3 ist zur Bildung der Stromspiegel-Steuerdiode nicht wie üblich direkt mit dem Drain-Anschluß verbunden, sondern erst nach dem Widerstand Rb. Damit addiert sich der durch den Drainstrom gebildete Spannungsabfall am Widerstand Rb zur Spannung am Drain-Anschluß. Der Gate-Anschluß des verkoppelten Transistors t4 ist mit dem Drain-Anschluß des Transistors t3 und nicht wie üblich mit dessen Gate-Anschluß verbunden.

Die Transistoren t3 und t5 bilden über ihre miteinander verbundenen Drain-Source-Strecken einen ersten und die Transistoren t4 und t6 einen zweiten Strompfad. Durch eine Vorgabe unterschiedlicher *w/l*-Verhältnisses der Transistoren t3, t4 bzw. t5, t6 wird in jedem Stromspiegel das Stromübersetzungsverhältnis zwischen eingespeistem und abgegebenem Strom definiert. Beim ersten Stromspiegel t3, t4 sind jedoch noch zusätzlich die unterschiedlichen Gate-Source-Spannungen zu berücksichtigen. Die unterschiedlichen Gate-Source-Spannungen erzwingen unterschiedliche Stromdichten in den beiden Transistoren t3, t4. Da die Höhe der Gate-Source-Spannungsdifferenz vom Strom im ersten Strompfad abhängt, hängt auch die jeweilige Stromdichte und damit das Stromübersetzungsverhältnis des ersten Stromspiegels t3, t4 von diesem Strom ab.

Im Ausführungsbeispiel der Bias-Schaltung von Fig. 9 verhalten sich die *w/l*-Verhältnisse der Transistoren t3 und t4 wie 1:2 und der Transistoren t5 und t6 wie 2:1. Somit erzwingt der zweite Stromspiegel im ersten und zweiten Strompfad Ströme im Verhältnis 2:1. Da das $w/l$-Verhältnis der Transistoren t3 und t4 im ersten Stromspiegel 1:2 beträgt, ergibt sich für diese Ströme eine resultierende Stromdichte in den Transistoren t3 und t4 von 1:4. Wegen der quadratischen Abhängigkeit des Drain-Stromes von der Gate-Source-Spannung bei MOS-Transistoren ist dieser Zustand im ersten Stromspiegel nur für diejenigen Betriebszustände gültig, in denen die Gate-Source-Spannung von Transistor t3 doppelt so groß wie die von Transistor t4 ist. Da die beiden zusammengekoppelten Stromspiegel eine Regelschaltung bilden, stellt sich dieser stabile Zustand in Abhängigkeit von der Größe des Widerstandes Rb unabhängig von der Höhe der Versorgungsspannung Vdd für einen Betriebszustand ein, der durch den Stromwert $I$ definiert ist. Der Strom $I$ ist also letztendlich eine Funktion von Rb. Im stationären Betriebszustand fließt ein geregelter Strom vom Wert $I$ und über den ersten Strompfad und ein geregelter Strom vom Wert $I/2$ über den zweiten Strompfad. Dabei ergibt sich die Höhe des Stromes $I$ aus folgender Gleichung 12:

$$I = \frac{1}{4\frac{w}{l}\,\beta'\cdot R_b^2} \qquad \text{(Gleichung 12)}$$

Hierbei ist β' ein technologischer Parameter, in den die Gate-Oxiddicke und die Beweglichkeit der Ladungsträger in den Kanälen der Transistoren t3, t4 eingeht und der somit eine vom Herstellungsprozeß abhängige Steilheit dieser Transistoren angibt. Vorteilhafterweise sind die Transistoren t3 und t4 vom gleichen Leitfähigkeitstyp und befinden sich in einem ähnlichen Arbeitspunkt wie die steilheitsbestimmenden Eingangstransistoren des Transkonduktanz-Eingangsverstärkers 2 im Operationsverstärker Op. Über andere $w/l$- Verhältnisse und andere Gate-Source-Spannungsverhältnisse der Transistoren t3, t4 lassen sich selbstverständlich auch andere Verhältnisse der Ströme als $I$ und $I/2$ einstellen. Mit $I$ und $I/2$ ergibt sich für den Transistor t3 mit dem Strom I eine Steilheit $g_m^*$, die umgekehrt proportional zu $R_b$ ist. Da die Stromquelle, nämlich Transistor t7, für den Eingangsverstärker 2 einen Strom $I$ liefert, der gleich dem Strom $I$ im ersten Strompfad t3, t4 der Bias-Schaltung 1 ist, verhält sich die Steilheit $g_m$ des Eingangsverstärkers 2 umgekehrt proportional zum strombestimmenden Widerstand $R_b$ im ersten Strompfad t3, t4:

$$g_m \quad \propto \quad g_m^* = 1/R_b \qquad \text{(Gleichung 13)}$$

Um die Transitfrequenz $f_T$ des Operationsverstärkers Op mit den Widerständen und Kapazitäten des RC-Netzwerks möglichst gut abzustimmen, empfiehlt es sich, den steilheitsbestimmenden Widerstand Rb der Bias-Schaltung 1 mit denselben Herstellungsprozessen wie die Widerstände und Kondensatoren des äußeren Gegenkopplungsnetzwerkes sowie den Miller-Kondensator des Operationsverstärkers Op zu implementieren. Damit wird ein Gleichlauf der Transitfrequenz $f_T$ des Operationsverstärkers entsprechend $2\pi f_T = g_m/C$ mit den Kehrwerten der RC-Zeitkonstanten der Gegenkopplung erreicht.

Um beim Einschalten der Spannungsversorgung Vdd den Regelkreis in der Bias-Schaltung 1 aus dem stromlosen Arbeitspunkt zu ziehen, ist eine Starteinrichtung 5 erforderlich. Sie kann beispielsweise einen hochohmigen Widerstand nach Masse enthalten, über den ein im Vergleich zum Strom $I$ sehr kleiner Strom fließt, der jedoch zum Starten der Regelschleife ausreichend ist. Gegebenenfalls kann dieser Strom im normalen Betriebszustand wieder abgeschaltet werden, beispielsweise über einen vom ersten oder zweiten Stromspiegel t3, t4 bzw. t5, t6 gesteuerten, der Übersicht wegen jedoch nicht dargestellten Schalter.

Fig. 10 zeigt schließlich schematisch als Blockschaltbild ein Anwendungsbeispiel für die aktive Filterschaltung nach der Erfindung. Ein Tuner 6 liefert an seinem Ausgang ein Frequenzgemisch in einer Zwischenfrequenzlage. Dieses Frequenzgemisch enthält einen interessierenden Kanal, der mit einer monolithisch integrierten Schaltung 7 weiterverarbeitet wird. Dieser Kanal liegt im Ausführungsbeispiel etwa im Bereich von 40 MHz und ist einem Träger mit der Frequenz f1 zugeordnet. Der interessierende Kanal wird dabei entweder bereits im Tuner oder mittels eines nicht dargestellten Oberflächenwellenfilters aus dem gesamten Frequenzgemisch herausgefiltert. Die monolithisch integrierte Schaltung 7 enthält am Eingang einen Mischer 8, in der Regel ein Quadraturmischer, der den bei 40 MHz liegenden Kanal in das Basisband oder ein tiefes Frequenzband für die weitere Verarbeitung umsetzt. Zur Frequenzumsetzung erzeugt ein am Träger f1 orientierter Oszillator 9 ein passendes Oszillatorsignal fo. Das Ausgangssignal des Mischers 8 liefert den umgesetzten Kanal in der gewünschten tiefen Frequenzlage, wobei der umgesetzte Träger f2 nun bei der Differenzfrequenz f2 = f1 - fo liegt.

Die bei der Mischung entstehenden Summensignale werden mittels eines Tiefpasses 10 abgetrennt. Dem Tiefpaß folgt ein Analog-Digital-Umsetzer 11, an den eine digitale Signalverarbeitungseinheit 12 angeschlossen ist, in der die weitere Signalverarbeitung stattfindet. Als gestrichelte Pfeile sind in Fig. 10 Störsignale fn dargestellt, die im Ausgangssignal des Mischers 8 enthalten sein können. Damit der Tiefpaß 10 diese Störsignale unterdrücken kann, muß er gegebenenfalls eine sehr steile Tiefpaßflanke aufweisen, um eventuell auch sehr naheliegende Störsignale fn ausreichend zu unterdrücken. Als direkte Störsignale kommen in Frage: das Oszillatorsignal fo, das eine hohe Amplitude aufweist, das Ausgangssignal des Tuners 6 unter Einschluß der ungenügend unterdrückten Nachbarkanäle, Signale die mit dem Digitalisierungstakt verkoppelt sind und Signale aus der Signalverarbeitungseinheit 12. Daneben gibt es indirekte Störsignale geringerer Amplituden durch Mischung und Oberwellen vorhandener Signale. Über parasitäre Mischungen an nichtlinearen Kennlinien können diese Signale ebenfalls in die Nähe des Basisbandes gelangen. Mit der Erfindung lassen sich die erforderlichen steilflankigen Tiefpaßfilter realisieren, die als aktive Filter einfach zu berechnen sind, eine relativ geringe Stromaufnahme aufweisen und ein wesentliches Erfordernis der monolithisch integrierbaren Mischungseinrichtung 8 mit nachfolgender Digitalisierung und Signalverarbeitung sind.

**Patentansprüche**

1. Aktive Filterschaltung mit einem Operationsverstärker (Op), dessen Frequenzgang in Verbindung mit einem in der aktiven Filterschaltung enthaltenen RC-Netzwerk ($R_1$, $R_2$, $C_1$, $C_2$) der Bestimmung einer vorgegebenen Tiefpaßcharakteristik dient, wobei der Frequenzgang des Operationsverstärkers integraler Bestandteil dieser vorgegebenen Tiefpaßcharakteristik ist, **dadurch gekennzeichnet, daß** der Operationsverstärker (Op) einen Transkoriduktanzverstärker (2, 3, 4) enthält, der über seine Steilheit ($g_m$) und einen Kondensator (Cc) im wesentlichen den Frequenzgang des Operationsverstärkers bestimmt.

2. Filterschaltung nach Anspruch 1, **dadurch gekennzeichnet, daß** die Steilheit ($g_m$) des Transkonduktanzverstärkers (2, 3, 4) durch eine Bias-Schaltung (1) derart steuerbar ist, daß sie sich umgekehrt proportional zu einem steilheitsbestimmenden Widerstand (Rb) in dieser Bias-Schaltung (1) verhält, der von der gleichen Art ist wie die Widerstände (R1, R2) des RC-Netzwerkes ($R_1$, $R_2$, $C_1$, $C_2$),

3. Filterschaltung nach Anspruch 1 oder 2, **dadurch gekennzeichnet, daß** die strombestimmenden Transistoren in der Biasschaltung (1) vom selben Leitfähigkeitstyp sind und sich im wesentlichen im gleichen Arbeitspunkt befinden wie die von der Bias-Schaltung (1) gespeisten Eingangstransistoren des Transkonduktanzverstärkers (2, 3, 4).

4. Filterschaltung nach einem der vorhergehenden Ansprüche, **dadurch gekennzeichnet, daß** der Operationsverstärker (Op) im Bereich der vorgegebenen Tiefpaßcharakteristik eine im wesentlichen konstante Verstärkungsabsenkung von -20 dB/Dekade aufweist.

5. Filterschaltung nach einem der vorhergehenden Ansprüche, **dadurch gekennzeichnet, daß** das RC-Netzwerk ($R_1$, $R_2$, $C_1$, $C_2$) in Verbindung mit dem Operationsverstärker (Op) eine Filterschaltung zweiter Ordnung bildet.

6. Filterschaltung nach einem der vorhergehenden Ansprüche, **dadurch gekennzeichnet, daß** das RC-Netzwerk ($R_1$, $R_2$, $C_1$, $C_2$) und der Operationsverstärker (Op) Teile einer einzigen monolithisch integrierten Schaltung sind, wobei die frequenzgangbestimmenden Widerstände ($R_1$, $R_2$) und/oder Kondensatoren ($C_1$, $C_2$) des RC-Netzwerkes und des Operationsverstärkers jeweils nach den gleichen Herstellungsverfahren hergestellt sind.

7. Filterschaltung nach einem der Ansprüche 2 bis 6, **dadurch gekennzeichnet, daß** das RC-Netzwerk ($R_1$, $R_2$, $C_1$, $C_2$) und der den Transkonduktanzverstärker (2, 3, 4) enthaltende Operationsverstärker (Op) Teile einer einzigen monolithisch integrierten Schaltung sind, wobei die frequenzgang- und steilheitsbestimmenden Widerstände ($R_1$, $R_2$, Rb) und/oder frequenzgangbestimmenden Kondensatoren ($C_1$, $C_2$, Cc) des RC-Netzwerkes und des Transkonduktanzverstärkers mit der Bias-Schaltung (1) jeweils nach den gleichen Herstellungsverfahren hergestellt sind.

8. Filterschaltung nach einem der Ansprüche 1 bis 7, **dadurch gekennzeichnet, daß** vor oder nach der Filterschaltung der Signalpfad zur Unterdrückung von Gleichspannungssignalen und tiefen Frequenzen kapazitiv aufgetrennt ist.

9. Filterschaltung nach einem der Ansprüche 1 bis 8, **dadurch gekennzeichnet, daß** die Schaltung des Operationsverstärkers (Op) bezüglich der beiden mit dem invertierenden und nichtinvertierenden Eingang (EI, E2) verkoppelten Signalpfade im wesentlichen symmetrisch ist, wobei der Operationsverstärker einen invertierenden und einen nichtinvertierenden Ausgang (P2, P1) aufweist.

10. Filterschaltung nach Anspruch 9, **dadurch gekennzeichnet, daß** das RC-Netzwerk symmetrisch ist, wobei die Symmetrierung des dem invertierenden Eingang (E1) und nichtinvertierenden Ausgang (P1) des Operationsverstärkers (Op) zugeordneten ersten RC-Netzwerkes ($R_1$, $R_2$, $C_1$, $C_2$) durch ein dem nichtinvertierenden Eingang (E2) und invertierenden Ausgang (P2) des Operationsverstärkers zugeordnetes symmetrisches RC-Netzwerk ($R_1^*$, $R_2^*$, $C_1^*$, $C_2^*$) erfolgt, dessen Dimensionierung identisch zur Dimensionierung des ersten RC-Netzwerkes ist.

**11.** Filterschaltung nach einem der Ansprüche 1 bis 10, **dadurch gekennzeichnet, daß** die Filterschaltung einem, insbesondere einem mitintegrierten, Mischer (8) nachgeschaltet ist, um störende Signale (fn) vor der weiteren Verarbeitung abzutrennen.

**12.** Filterschaltung höherer als zweiter Ordnung mit mindestens einer Filterschaltung nach einem der Ansprüche 1 bis 11.


## Claims

**1.** An active filtering circuit comprising an operational amplifier (Op), the frequency response of which, in conjunction with an RC network ($R_1$, $R_2$, $C_1$, $C_2$) included in the active filtering circuit, serves for determining a preset low-pass characteristic, the frequency response of the operational amplifier being an integral component of this preset low-pass characteristic, **characterised in that** the operational amplifier (Op) includes a transconductance operational amplifier (2, 3, 4), which largely determines the frequency response of the operational amplifier through its transconductance ($g_m$) and a capacitor (Cc).

**2.** The filtering circuit according to claim 1, **characterised in that** the transconductance ($g_m$) of the transconductance operational amplifier (2, 3, 4) is controllable through a bias circuit (1) such that it behaves so as to be inversely proportional to a transconductance-determining resistor (Rb) in this bias circuit (1), which resistor is of the same type as the resistors (R1, R2) of the RC network ($R_1$, $R_2$, $C_1$, $C_2$).

**3.** The filtering circuit according to claim 1 or 2, **characterised in that** the current-determining transistors in the bias circuit (1) are of the same conductivity type and essentially are in the same operating point like the input transistors of the transconductance operational amplifier (2, 3, 4) which are fed by the bias circuit (1).

**4.** The filtering circuit according to any of the preceding claims, **characterised in that** the operational amplifier (Op) has a substantially constant gain reduction of -20dB/decade in the range of the preset low-pass characteristic.

**5.** The filtering circuit according to any of the preceding claims, **characterised in that** the RC network ($R_1$, $R_2$, $C_1$, $C_2$) in conjunction with the operational amplifier (Op) forms a filtering circuit of second order.

**6.** The filtering circuit according to any of the preceding claims, **characterised in that** the RC network ($R_1$, $R_2$, $C_1$, $C_2$) and the operational amplifier (Op) are parts of a single monolithically integrated circuit, with the resistors ($R_1$, $R_2$) and/or capacitors ($C_1$, $C_2$), which are determinative for the frequency response, of the RC network and of the operational amplifier, are each produced according to the same production methods.

**7.** The filtering circuit according to any of the claims 2 to 6, **characterised in that** the RC network ($R_1$, $R_2$, $C_1$, $C_2$) and the operational amplifier (Op) including the transconductance operational amplifier (2, 3, 4) are parts of a single monolithically integrated circuit, with the resistors ($R_1$, $R_2$, Rb) which are determinative for the frequency response and the transconductance, and/or the capacitors ($C_1$, $C_2$, Cc), which are determinative for the frequency response, of the RC network and of the transconductance operational amplifier including the bias circuit (1), are each produced according to the same production methods.

**8.** The filtering circuit according to any of the claims 1 to 7, **characterised in that** upstream or downstream of the filtering circuit the signal path is capacitively separated for the suppressing of direct voltage signals and low frequencies.

**9.** The filtering circuit according to any of the claims 1 to 8, **characterised in that** the circuitry of the operational amplifier (Op) is substantially symmetrical with regard to the two signal paths which are coupled with the inverting and non-inverting inputs (E1, E2), the operational amplifier having inverting and non-inverting outputs (P1, P2).

**10.** The filtering circuit according to claim 9, **characterised in that** the RC network is symmetrical, and effecting the symmetry of the first RC network ($R_1$, $R_2$, $C_1$, $C_2$) associated to the inverting input (E1) and the non-inverting output (P1) of the operational amplifier (Op) is accomplished by a symmetrical RC network ($R_1^*$, $R_2^*$, $C_1^*$, $C_2^*$) which is

associated to the non-inverting input (E2) and the inverting output (P2) of the operational amplifier and has the same dimensioning as the dimensioning of the first RC network.

11. The filtering circuit according to any of the claims 1 to 10, **characterised in that**, for separating interfering signals (fn) from the further processing, the filtering circuit is disposed downstream a mixer (8), which in particular is a co-integrated mixer.

12. A filtering circuit higher than of second order, comprising at least one filtering circuit according to any of the claims 1 to 11.

**Revendications**

1. Circuit de filtrage actif comportant un amplificateur opérationnel (Op), dont la caractéristique de réponse en fréquence sert, en combinaison avec un réseau RC ($R_1$,$R_2$, $C_1$, $C_2$) qui est contenu dans le circuit de filtrage actif, à la détermination d'une caractéristique de filtrage passe-bas prédéterminée, **caractérisé en ce que** l'amplificateur opérationnel (Op) contient un amplificateur à transducteur (2, 3, 4) qui détermine au moyen de sa pente *($g_m$)* et d'un condensateur (Cc) détermine, pour l'essentiel, la caractéristique de réponse en fréquences.

2. Circuit de filtrage actif selon la revendication 1, **caractérisé en ce que** la pente ($g_m$) de l'amplificateur à transducteur (2, 3, 4) peut être commandée par un circuit de polarisation (1) de telle manière que ladite pente se comporte de manière inversement proportionnelle à une résistance (Rb) qui détermine la pente, qui se trouve dans le circuit de polarisation (1) et qui est du même type que les résistances (R1, R2) du réseau RC (R1,R2, C1, C2).

3. Circuit de filtrage actif selon la revendication 1 ou 2, **caractérisé en ce que** les transistors qui déterminent le courant dans le circuit de polarisation (1) sont du même type de conduction et se trouvent, pour l'essentiel, au même point de fonctionnement dynamique que les transistors d'entrée du l'amplificateur à transducteur (2, 3, 4) qui sont alimentés par le circuit de polarisation (1).

4. Circuit de filtrage actif selon l'une quelconque des revendications précédentes, **caractérisé en ce que** l'amplificateur opérationnel (Op) présente, dans la zone de la caractéristique de filtrage passe-bas prédéterminée, une diminution sensiblement constante de l'amplification de 20 dB par décade.

5. Circuit de filtrage actif selon l'une quelconque des revendications précédentes, **caractérisé en ce que** le réseau RC (R1,R2, C1, C2) constitue, en combinaison avec l'amplificateur opérationnel (Op), un circuit de filtrage de deuxième ordre.

6. Circuit de filtrage actif selon l'une quelconque des revendications précédentes, **caractérisé en ce que** le réseau RC (R1,R2, C1, C2) et l'amplificateur opérationnel (Op) sont des parties d'un circuit monolithique intégré unique, alors que les résistances (R1,R2) et/ou les condensateurs (C1, C2) du réseau RC et de l'amplificateur opérationnel (Op) qui déterminent la caractéristique de réponse en fréquence sont, à chaque fois, fabriqués avec le même procédé de fabrication.

7. Circuit de filtrage actif selon l'une quelconque des revendications 2 à 6, **caractérisé en ce que** le réseau RC (R1, R2, C1, C2) et l'amplificateur opérationnel (Op) contenant l'amplificateur à transducteur (2, 3, 4) sont des parties d'un circuit monolithique intégré unique, alors que les résistances (R1, R2) et/ou les condensateurs (C1, C2) du réseau RC et de l'amplificateur opérationnel (Op) qui déterminent la caractéristique de réponse en fréquence et la pente sont, à chaque fois, avec le circuit de polarisation (1), fabriqués avec le même procédé de fabrication.

8. Circuit de filtrage actif selon l'une quelconque des revendications 1 à 7, **caractérisé en ce que**, avant ou après le circuit de filtrage, le trajet du signal est séparé de manière capacitive pour la suppression des signaux à courant continu et des fréquences basses.

9. Circuit de filtrage actif selon l'une quelconque des revendications 1 à 8, **caractérisé en ce que** le circuit de l'amplificateur opérationnel (Op) est sensiblement symétrique en ce qui concerne les deux trajets de signal qui sont reliés à l'entrée inverseuse et l'entrée non inverseuse (E1, E2) alors que l'amplificateur opérationnel (Op) comporte une sortie inverseuse et une sortie non inverseuse (P1, P2).

**10.** Circuit de filtrage actif selon la revendication 9, **caractérisé en ce que** le réseau RC est symétrique, alors que la symétrie du premier réseau RC (R1,R2, C1, C2) qui est associé à l'entrée inverseuse (E1) et à la sortie non inverseuse (P1) de l'amplificateur opérationnel (Op) est réalisée au moyen d'un deuxième réseau RC symétrique (R1*,R2*, C1*, C2*) qui est associé à l'entrée inverseuse (E2) et à la sortie non inverseuse (P2) de l'amplificateur opérationnel (Op) et dont le dimensionnement est identique à celui du premier réseau RC.

**11.** Circuit de filtrage actif selon l'une quelconque des revendications 1 à 10, **caractérisé en ce** le circuit de filtrage est branché en aval d'un circuit mélangeur (8) qui est, en particulier, intégré avec le reste du circuit de filtrage pour séparer des signaux perturbateurs (fn) avant un traitement ultérieur.

**12.** Circuit de filtrage d'un ordre supérieur à 2 comportant au moins un circuit de filtrage selon l'une quelconque des revendications 1 à 11.

**Fig.1**

**Fig.2**

**Fig.3**

$$\upsilon_{out} = -\upsilon_m \cdot \frac{\omega T}{p}$$

**Fig.4**

Fig.5

$\dfrac{|G(jw)|}{dB}$

A max
0 dB
A min

HP

−+40dB/Dekade

−80 dB/Dekade

−75dB

As
−75dB

$\omega_g$    $\omega_s$

$\log \omega$

0,5

8,24  ~60

$\dfrac{f}{MHz}$

Fig.6

Vdd

4

3

1

I

E1    E2

u1    u2

P2

P1

u6

u3    u4

t1    u8

id

Cc

u7

q8    nm

t2

pm

u5

Fig.7

E1    P1

$v_m$

u1    u5

u2

E2    P2    u6

Op

Fig.8

$\upsilon_{in}$

$\upsilon_{out}$

L1  R1

E1  P1

$\omega_r/p$

E2  Op  P2

L2  R1*

C1  C2

R2

C1*  R2*  C2*

Fig.9

Vdd

1w/l

2xw/l  $\underline{1}$  4xw/l  u9

t3  t7

5  I  Rb  u10  t4

$$I = \frac{1}{(4\frac{w}{l} \, \Pi' Rb^2)}$$

Start  I/2  I

t5  t6

2xw/l  1w/l

$$\overset{*}{gm}(t3) = \frac{1}{Rb}$$

gm  2

Fig.10

6  8  fn  f2+fn  f2

f1

Tuner  TP  A  12

f0  10  D

7  fn  11

9  fn  fn

14

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0460263 A

**In der Beschreibung aufgeführte Nicht-Patentliteratur**

- Halbleiter-Schaltungstechnik. **U. TIETZE ; CH. SCHENK.** Theoretische Grundlagen von Tiefpaßfiltern. Springer-Verlag, 1993, 391-413